(19) **Europäisches Patentamt**

**European Patent Office**

**Office européen des brevets**

(11) **EP 0 942 036 B1**

(12) **EUROPÄISCHE PATENTSCHRIFT**

(45) Veröffentlichungstag und Bekanntmachung des Hinweises auf die Patenterteilung:
**14.07.2004 Patentblatt 2004/29**

(51) Int Cl.⁷: **C08K 3/38**, C08K 3/16, C09J 201/00, C09J 201/02, C08K 3/22, C08K 3/26, C08K 3/34, C08K 5/098, C08K 5/057, C08K 5/00, C09J 11/04, C08G 59/24, C08G 59/68

(21) Anmeldenummer: **99103958.7**

(22) Anmeldetag: **09.03.1999**

(54) **Polymerisierbare fluorhaltige Zubereitung, ihre Verwendung und Verfahren zur Herstellung ausgehärteter Polymermassen aus dieser Zubereitung**

Polymerisable preparation containing fluor, its use and method of preparation of a polymer composition containg the preparation

Préparation polymérisable contenant du fluor, son utilisation et procédé de fabrication de composition de polymère durcit contenant cette préparation

(84) Benannte Vertragsstaaten:
**DE ES FR GB**

(30) Priorität: **11.03.1998 DE 19810549**

(43) Veröffentlichungstag der Anmeldung:
**15.09.1999 Patentblatt 1999/37**

(73) Patentinhaber: **DELO Industrieklebstoffe GmbH & Co. KG**
**86899 Landsberg (DE)**

(72) Erfinder:
• **Eckhardt, Gunther Dr.**
**82346 Frieding (DE)**
• **Dengler, Dietmar Dr.**
**86899 Landsberg (DE)**
• **Somnitz, Ursula**
**82362 Weilheim (DE)**

(74) Vertreter: **Bunke, Holger, Dr.rer.nat. Dipl.-Chem.**
**Prinz & Partner GbR**
**Manzingerweg 7**
**81241 München (DE)**

(56) Entgegenhaltungen:
**EP-A- 0 533 465**      **US-A- 4 548 989**

## Beschreibung

Die Erfindung betrifft eine polymerisierbare fluorhaltige Zubereitung und ihre Verwendung zur Herstellung ausgehärteter Polymermassen, die einen reduzierten Gehalt an mit Wasser extrahierbaren Fluoridionen enthalten. Weiterhin bezieht sich die Erfindung auf die Verwendung dieser Zubereitung als Klebstoff, Dichtstoff, Beschichtungs- und Vergußmaterial, und zwar vorzugsweise in solchen Anwendungsgebieten, bei denen ein hoher Gehalt an mit Wasser extrahierbaren Fluoridionen unerwünscht ist.

Es ist bekannt, für die Herstellung von durch Polyreaktionen aushärtenden Reaktionsmassen fluorhaltige Rezepturbestandteile einzusetzen. So werden beispielsweise fluorhaltige Monomere oder fluorhaltige Füllstoffe oder Zusatzmittel verwendet. Es ist ferner bekannt, fluorhaltige Initiatoren oder Katalysatoren einzusetzen, um ausreichende Härtungsgeschwindigkeiten zu erreichen. Der Einsatz von fluorhaltigen Photoinitiatoren, die perfluorierte Anionen aufweisen, ist weit verbreitet und wird in vielen Patentschriften, beispielsweise in der EP-B1-0 388 775, beschrieben.

Der Einsatz von Borfluorid-Komplexen als Katalysatoren für Polyreaktionen ist ebenfalls bekannt (vgl. Makromolekulare Chemie 191 (1990), 1403). Nachteilig bei der Verwendung von fluorhaltigen Rezepturbestandteilen in durch Polyreaktionen aushärtenden Zubereitungen ist der meist sehr hohe Gehalt der ausgehärteten Massen an mit Wasser extrahierbaren Fluoridionen. Dieser Anteil an leicht beweglichen Ionen kann bei der Anwendung der Zubereitungen unerwünscht sein. Bei der Anwendung der Zubereitungen für das Verkleben, Vergießen und Beschichten von elektronischen Bauelementen oder bei der Montage dieser Bauelemente kann ein hoher Anteil an mit Wasser extrahierbaren Fluoridionen zu Korrosionserscheinungen führen und damit die Funktionsfähigkeit der Bauelemente beeinträchtigen.

Der Erfindung liegt die Aufgabe zugrunde, polymerisierbare Zubereitungen vorzuschlagen, die fluorhaltige Rezepturbestandteile enthalten und zu ausgehärteten Massen mit reduziertem Gehalt an mit Wasser extrahierbaren Fluoridionen führen.

Diese Aufgabe wird erfindungsgemäß dadurch gelöst, daß die mindestens eine polymerisierbare Verbindung und mindestens eine fluorhaltige Verbindung enthaltende Zubereitung zusätzlich mindestens eine Magnesiumverbindung enthält und nach der Aushärtung einen niedrigen Gehalt an mit Wasser extrahierbaren Fluoridionen aufweist.

Es hat sich überraschenderweise gezeigt, daß durch den Zusatz mindestens einer Magnesiumverbindung der Gehalt der aus der polymerisierbaren Zubereitung erhaltenen ausgehärteten Polymermasse an solchen Fluoridionen, die mit Wasser extrahierbar sind, deutlich reduziert ist, verglichen mit dem mit Wasser extrahierbaren Fluoridionengehalt ausgehärteter Polymermassen bekannter Art, die sich von den erfindungsgemäß erhältlichen Massen nur dadurch unterscheiden, daß den polymerisierbaren fluorhaltigen Zubereitungen keine Magnesiumverbindung(en) zugesetzt werden. Vorzugsweise ist der Gehalt an mit Wasser extrahierbaren Fluoridionen nach der Aushärtung um mindestens 40% niedriger als der mit Wasser extrahierbare Fluoridionengehalt einer ansonsten identischen Zubereitung, die keine Magnesiumverbindung enthält. Besonders bevorzugt ist der nach der Aushärtung extrahierbare Fluoridionengehalt um mindestens 60% niedriger als ohne Magnesiumverbindung.

Die überraschende Wirkung des Zusatzes einer oder mehrerer Magnesiumverbindungen ist im bisher bekannt gewordenen Stand der Technik noch niemals beschrieben oder auch nur vermutet worden.

Bei einer vorteilhaften Ausführungsform der Erfindung enthält die polymerisierbare fluorhaltige Zubereitung die mindestens eine Magnesiumverbindung in einer Menge von 0,001 bis 60 Masseteilen, besonders bevorzugt von 0,01 bis 10 Masseteilen, jeweils je 100 Masseteile der Gesamtzubereitung.

Innerhalb der angegebenen Bereiche kann die erforderliche Konzentration der Magnesiumverbindung(en) in weiten Grenzen eingestellt werden. Im allgemeinen bewirken schon geringe Anteile einer Magnesiumverbindung, beispielsweise 0,05 Masseteile je 100 Masseteile der Zubereitung, eine deutliche Reduzierung des mit Wasser extrahierbaren Fluoridionengehalts der ausgehärteten Massen.

Die Magnesiumverbindungen können in gelöster oder in ungelöster Form in der flüssigen Zubereitung vorliegen.

Im Falle von in der Zubereitung löslichen Magnesiumverbindungen erfolgt die Zugabe in einfacher Weise während des Mischvorganges. Zwar sind lösliche Magnesiumverbindungen hinsichtlich der Reduzierung des mit Wasser extrahierbaren Fluoridionengehalts weniger wirksam als unlösliche Magnesiumverbindungen, aber sie bieten vor allem in niedrigviskosen Zubereitungen den Vorteil einer größeren Homogenität der Zubereitungen. Eine solche lösliche Magnesiumverbindung ist z.B. Magnesiumacetylacetonat, eine Magnesiumchelat-Verbindung.

Die wegen ihrer besseren Wirkung bevorzugten unlöslichen Magnesiumverbindungen können wegen des Absetzens von Feststoffteilchen in den Zubereitungen zu Inhomogenitäten führen. Um diese Gefahr zu verringern, sollte darauf geachtet werden, daß die Magnesiumverbindungen in sehr feinteiliger Form eingesetzt werden. Das Absetzen der Magnesiumverbindungen aus der flüssigen Zubereitung kann zusätzlich durch die Anwendung geeigneter Thixotropiermittel, wie beispielsweise pyrogener Kieselsäuren, die gegebenenfalls silanisiert sind, vermindert oder ganz verhindert werden.

Vorzugsweise ist die mindestens eine Magnesiumverbindung ausgewählt aus der aus Magnesiumoxid, Magnesiumhydroxid, Magnesiumcarbonat, Magnesiumsilikat, Magnesiumcarboxylaten, Magnesiumchelaten und Magnesiumalkoholaten bestehenden Gruppe. Besonders bevorzugt werden dabei die anorganischen Magnesiumverbindungen, insbesondere Magnesiumsilikat, Magnesiumcarbonat, Magnesiumhydroxid und Magnesiumoxid, und zwar jeweils allein oder im Gemisch miteinander.

Für viele Anwendungsfälle ist es zweckmäßig, besonders reine Magnesiumverbindungen zu verwenden.

Bei einer anderen bevorzugten Ausführungsform der Erfindung enthält die polymerisierbare Zubereitung die Magnesiumverbindung(en) in dispergierter, feinteiliger Form mit einer Korngröße von höchstens 50 μm.

Wenn Magnesiumoxid als eine der bevorzugten Magnesiumverbindungen eingesetzt wird, kann sowohl kaustische, gebrannte Magnesia als auch Sintermagnesia oder Schmelzmagnesia eingesetzt werden, wobei der Fachmann den jeweils günstigsten Typ in Abhängigkeit von der Zusammensetzung der polymerisierbaren fluorhaltigen Zubereitung auswählen kann.

Unter den organischen Magnesiumverbindungen sind Magnesiumcarboxylate und Magnesiumalkoholate bevorzugt. Je nach der Struktur des organischen Restes können diese Magnesiumverbindungen in der polymerisierbaren fluorhaltigen Zubereitung löslich oder unlöslich sein.

Abgesehen von der mindestens einen Magnesiumverbindung, kann die Zusammensetzung der polymerisierbaren fluorhaltigen Zubereitung im übrigen sehr unterschiedlich sein. Der Mechanismus der Aushärtung der Zubereitung (kationisch, anionisch, radikalisch oder durch Polykondensation) spielt dabei keine Rolle.

Bei einer weiteren bevorzugten Ausführungsform der Erfindung ist die mindestens eine polymerisierbare Verbindung eine mindestens eine Epoxidgruppe enthaltende Verbindung, die aus der aus Glycidylethern und Epoxycyclohexylgruppen enthaltenden Verbindungen bestehenden Gruppe ausgewählt ist.

Bevorzugt werden aliphatische, cycloaliphatische und/oder aromatische Epoxidharze, die fluorhaltig sein können, eingesetzt. Typische Vertreter dieser Verbindungsklasse sind die Diglycidylether von Bisphenolen, die Glycidylether von Novolaken und Epoxycyclohexylgruppen enthaltende Verbindungen wie beispielsweise das 3,4-Epoxycyclohexylmethyl-3',4'epoxycyclohexylcarboxylat oder das Bis(3,4-epoxycyclohexylmethyl)adipat.

Es können aber auch fluorhaltige (Meth)acrylate als polymerisierbare Verbindungen verwendet werden.

Der erfindungsgemäße Einsatz von mindestens einer Magnesiumverbindung zur Fluoridionenreduzierung im wäßrigen Extrakt der ausgehärteten Polymermassen ist dann besonders sinnvoll, wenn zur Erzielung bestimmter Effekte bei der Aushärtung oder im Gebrauch der Polymermassen fluorhaltige Rezepturbestandteile eingesetzt werden oder eingesetzt werden müssen. Das ist beispielsweise bei der kationischen Polymerisation von Epoxidharzen der Fall, bei der üblicherweise Iodonium-, Sulfonium- oder Ferroceniumverbindungen mit einem komplexen fluorhaltigen Anion als Katalysatoren oder Initiatoren eingesetzt werden. Bevorzugt verwendete Anionen sind Tetrakis(pentafluorophenyl)borat, Hexafluoroantimonat, Hexfluoroarsenat, Hexafluorophosphat und Tetrafluoroborat, wobei die Fluoratome in diesen komplexen Anionen teilweise durch Hydroxylgruppen substituiert sein können.

Für die Polymerisation von Epoxidharzen werden als Härter häufig Borfluoridkomplexe eingesetzt, beispielsweise die Komplexe des Borfluorids mit Wasser, Alkoholen, Ethern, Thioethern, Ammoniak, Aminen, Carbonsäuren, Ketonen und Aldehyden. Eine bevorzugte Verbindungsklasse dieser Komplex-Härter stellen die Borfluoridkomplexe mit sekundären Aminen dar.

Gemäß einer weiteren bevorzugten Ausführungsform der Erfindung enthält die polymerisierbare fluorhaltige Zubereitung zusätzlich mindestens einen feinteiligen Füllstoff, ausgewählt aus der aus Quarzmehl, Quarzgutmehl und pyrogener Kieselsäure bestehenden Gruppe.

Bei hochpolymeren Füll- und Verstärkungsstoffen, so z.B. bei Gläsern und mineralischen Füllstoffen, die zumindest teilweise mit Magnesium dotiert sind, kann es zweckmäßig sein, die Konzentration der vorzugsweise festen Magnesiumverbindung(en) bis auf die angegebene Obergrenze von 60 Masseteilen je 100 Masseteile der Gesamtzubereitung zu erhöhen.

Die Wirkung der Magnesiumverbindung(en) hinsichtlich der Fluoridionenreduzierung im wäßrigen Extrakt tritt auch in Anwesenheit der feinteiligen Füllstoffe mit großer Oberfläche in der beschriebenen Weise ein.

Die erfindungsgemäße Zubereitung wird in Anwendungsgebieten eingesetzt, bei denen ein niedriger Gehalt an mit Wasser extrahierbaren Fluoridionen erforderlich ist. Solche Anwendungsgebiete sind beispielsweise das Verkleben, Vergießen und Beschichten von elektronischen Bauelementen, die Montage elektronischer Bauelemente auf Leiterplatten sowie die Herstellung medizintechnischer Artikel. Ein wichtiger Anwendungsbereich ist die Verklebung und Beschichtung medizintechnischer Artikel, die mit Körperflüssigkeiten in Berührung kommen können, beispielsweise Dialysefilter, Katheder, Verweilkanülen, Herzschrittmacher, Arthroskopiegeräte, implantierbare Hörgeräte und künstliche Gelenke. In diesem Bereich kommt es entscheidend darauf an, das "Ausbluten" toxischer Fluoridionen aus der ausgehärteten Polymermasse so weit wie möglich zu verringern und die Osmolalität der Körperflüssigkeiten nicht zu verändern.

Gegenstand der Erfindung ist schließlich ein Verfahren zur Herstellung ausgehärteter Polymermassen mit reduziertem Gehalt an mit Wasser extrahierbaren Fluoridionen, bei dem eine polymerisierbare fluorhaltige Zubereitung, die mindestens eine polymerisierbare Verbindung und mindestens eine fluorhaltige Verbindung enthält, polymerisiert und ausgehärtet wird, wobei das Verfahren dadurch gekennzeichnet ist, daß der fluorhaltigen Zubereitung vor der Polymerisation mindestens eine Magnesiumverbindung zugesetzt wird.

Dabei wird die mindestens eine Magnesiumverbindung vorzugsweise in einer Menge von 0,001 bis 60, besonders bevorzugt von 0,01 bis 10 Masseteilen je 100 Masseteile der Gesamtzubereitung zugesetzt.

Die Magnesiumverbindung wird vorzugsweise ausgewählt aus der aus Magnesiumoxid, Magnesiumhydroxid, Magnesiumcarbonat, Magnesiumsilikat, Magnesiumcarboxylaten, Magnesiumchelaten und Magnesiumalkoholaten bestehenden Gruppe.

Besonders vorteilhaft ist es, die Magnesiumverbindung in dispergierter, feinteiliger Form mit einer Korngröße von höchstens 50 μm zuzusetzen.

Als fluorhaltige Zubereitung wird bei dem erfindungsgemäßen Verfahren vorzugsweise eine solche eingesetzt, wie sie vorstehend beschrieben worden ist.

Die Erfindung wird nachfolgend anhand von Beispielen näher erläutert.

Sämtlichen Beispielen und Vergleichsbeispielen liegen folgende Arbeitsabläufe zugrunde, soweit nichts anderes angegeben ist:

Aushärtung der flüssigen Massen

1. Strahlungshärtung:

Die homogenen Massen werden in einer Teflon-Gießform mit einer UV-Lampe (Lux 03 der Firma DELO Industrieklebstoffe) bei einer Intensität von 50 mW/cm$^2$ 30 Sekunden lang von jeder Seite belichtet. Es resultieren Prüfkörper mit den Abmessungen 10 x 60 x 1 mm.

2. Warmhärtung:

Die homogenen Massen werden in einer Teflon-Gießform 1 Stunde bei 120°C ausgehärtet.

Extraktion

Zur Extraktion wird eine Apparatur, bestehend aus den nachfolgenden Bestandteilen, verwendet:

- Ölbad
- Rückflußkühler
- Rundkolben

Die ausgehärteten Folienstreifen werden in der Mitte einmal durchgebrochen und in den Extraktionskolben eingewogen.

| Einwaage: | -ca. 5 g Folienstreifen auf 0,1 mg genau |
| | -48 g destilliertes Wasser |
| | -0,250 g Triton X-100 p.a. (Firma Merck, Art. Nr. 1.08603.1000) |
| Die Blindwertprobe enthält: | -48 g destilliertes Wasser |
| | -0,250 g Triton X-100 (s.o.) |

Es wird 24 Stunden bei 100°C unter Rückfluß extrahiert.

Bestimmung des Fluoridgehalts

| Geräte: | Ionenmeter pMX 3000 |
| | Fluoridsensitive Elektrode |
| | Bezugselektrode |
| Reagenzien: | TISAB-Probenkonditionierlösung |
| | (WTW Best.-Nr.: 140100) |
| | 1000 ppm Fluoridstandardlösung |
| Standards: | 0,1 ppm und 20 ppm Fluorid in $H_2O$ dest. |

| Durchführung: | Jeweils 10,0 ml Extrakt bzw. Standardlösung werden mit 10,0 ml TISAB-Lösung versetzt. |
|---|---|

Vor der Bestimmung wird durch direktpotentiometrische Messung mit den zwei Standardlösungen eine Kalibrierung durchgeführt. Anschließend werden die Probelösungen vermessen.

Berechnung:

Fluoridmenge im Extrakt* [ppm] =

$$\frac{[\text{ppm F-(extr.)} - \text{ppm F- (Blindwert)}] \cdot \text{mm(extr.) [g]}}{\text{m (ausgehärtete Masse) [g]}}$$

\* bezogen auf je 1 g der ausgehärteten Masse.

Vergleichsbeispiel 1:

Es wird eine Mischung aus 34,33 Gew.-% eines cycloaliphatischen Epoxidharzes (Sarcat K 126 der Firma Cray Valley), 45 Gew.-% eines partiell epoxidierten Polybutadiendiols (Poly bd 600 der Firma elf atochem) und 0,67 % eines Triarylsulfoniumhexafluoroantimonats (UVI 6974 der Firma UCC) unter Lichtausschluß hergestellt. Unmittelbar nach der Herstellung wird photochemisch ausgehärtet, dann extrahiert und der Fluoridionengehalt bestimmt.

Beispiele 1-4:

Der in Vergleichsbeispiel 1 beschriebenen Lösung werden verschiedene Magnesiumverbindungen in unterschiedlicher Menge zugesetzt.
Die Tabelle zeigt die gefundene Menge an extrahierten Fluoridionen der ausgehärteten Grundrezeptur und von Magnesiumverbindungen enthaltenden Rezepturen:

| Bsp.Nr. | Zugesetzte Magnesiumverbindung | (%) | Menge Fluorid im Extrakt [ppm] |
|---|---|---|---|
| Vgl.-Bsp. | Grundrezeptur | ohne | 460 |
| 1 | Magnesiumhydroxid (Firma Merck) | 1 | 3 |
| 2 | Magnesiumsilikat (Firma Woelm) | 1 | 6 |
| 3 | Magnesiumoxid (Anscor P d.Fa.Redland Minerals) | 1 | 6 |
| 4 | Magnesiumoxid | 0,1 | 7 |

Vergleichsbeispiel 2:

33% eines cycloaliphatischen Epoxidharzes (Sarcat K 126 der Firma Cray Valley), 25% eines Polycarbonatdiols der mittleren Molmasse 510 und 41,5% eines silanisierten Quarzgutmehles werden intensiv vermischt. Unter Lichtausschluß werden 0,5% eines Triarylsulfoniumhexafluoroantimonats (UVI 6974 der Firma UCC) eingerührt.
Die photochemisch ausgehärteten Prüfkörper erbringen nach der Extraktion einen Fluoridionengehalt von 65 ppm.

Beispiel 5:

Der Zusatz von 0,1% Magnesiumoxid (Anscor P der Firma Redlands Minerals) zur Lösung des Vergleichsbeispiels 2 reduziert den extrahierbaren Fluoridionengehalt auf 13 ppm.

Vergleichsbeispiel 3:

Es werden 50,5% cycloaliphatisches Epoxidharz (Sarcat K 126 der Firma Cray Valley) mit 45,0% eines partiell epoxidierten Polybutadiendiols (Poly bd 600 der Firma elf atochem) und 3,0% Cumolhydroperoxid (80%ig in Cumol) (Trigonox K 80 der Firma Akzo Nobel) intensiv vermischt. Unter Ausschluß von Licht werden 1,5% einer 50%igen Lösung von η5-2,4-Cyclopentadien-1yl-[η(1,2,3,4,5,6)-(1-methylethyl)-benzol]eisen(1+)hexafluoroantimonat(1-), in Propylencarbonat eingerührt. Die photochemisch ausgehärteten Prüfkörper zeigen nach der Extraktion einen Fluoridionengehalt von 1200 ppm.

Beispiel 6:

Durch Zusatz von 0,1% Magnesiumoxid (Anscor P der Firma Redlands Minerals) zur in Vergleichsbeispiel 3 beschriebenen Lösung konnte eine Verminderung auf 6 ppm erreicht werden.

Vergleichsbeispiel 4:

54,5% cycloaliphatisches Epoxidharz (Sarcat K 126 der Firma Cray Valley) und 45% Poly bd 600 (Firma elf atochem) werden intensiv homogenisiert. Unter Lichtausschluß werden 0,5% eines Diaryliodonium(1+)tetrakis(pentafluorphenyl)borat(1-) (Rhodorsil 2074 der Firma Rhöne Poulenc) eingerührt. Die photochemisch ausgehärteten Prüfkörper der Lösung erbringen bei der Fluoridionenbestimmung des Extraktes 520 ppm Fluorid.

Beispiel 7:

Bei Zusatz von 0,1% Magnesiumoxid (Anscor P der Firma Redlands Minerals) zur Vergleichslösung 4 wird ein Gehalt von 5 ppm Fluorid im Extrakt gemessen.

Vergleichsbeispiel 5:

84% eines cycloaliphatischen Epoxidharzes (Uvacure 1500 der Firma UCB) werden mit 10% eines Polycarbonatdiols der mittleren Molmasse 510 und 3% eines Haftvermittlers auf Silanbasis homogen vermischt. Unter vorsichtigem Rühren werden 3% eines flüssigen Bortrifluorid-Aminkomplexes (Anchor 1040 der Firma Anchor) zugegeben. Die Aushärtung erfolgt durch Erhitzen auf 120°C für 1 Stunde. Die Bestimmung des Extrakts erbrachte eine Fluoridmenge von 470 ppm.

Beispiel 8:

Durch Zusatz von 1% feinteiligem Magnesiumoxid (Anscor P der Firma Redlands Minerals) zur in Vergleichsbeispiel 5 beschriebenen Lösung konnte die Menge der extrahierbaren Fluoridionen auf 260 ppm gesenkt werden.

**Patentansprüche**

1. Polymerisierbare fluorhaltige Zubereitung, enthaltend mindestens eine polymerisierbare Verbindung und mindestens eine fluorhaltige Verbindung, die ausgewählt ist aus der Gruppe: Tetrakis(pentafluorophenyl)borat, Hexafluoroantimonat, Hexafluoroarsenat, Hexafluorophosphat, Tetrafluoroborat, einem Komplex von Borfluorid mit Wasser, Alkoholen, Ethern, Thioethern, Ammoniak, Aminen, Carbonsäuren, Ketonen und Aldehyden und/oder einem Komplex von Borfluorid mit Verbindungen, die mindestens eine sekundäre Aminogruppe aufweisen, sowie zusätzlich mindestens eine Magnesiumverbindung, **dadurch gekennzeichnet, daß** sie nach der Aushärtung einen Gehalt an mit Wasser extrahierbaren Fluoridionen aufweist, der um mindestens 40% niedriger ist als der mit Wasser extrahierbare Fluoridionengehalt einer ansonsten identischen Zubereitung, die keine Magnesiumverbindung enthält.

2. Zubereitung nach Anspruch 1, **dadurch gekennzeichnet, daß** der nach der Aushärtung extrahierbare Fluoridionengehalt um mindestens 60% niedriger als ohne Magnesiumverbindung ist.

3. Zubereitung nach Anspruch 1 oder 2, **dadurch gekennzeichnet, daß** sie die mindestens eine Magnesiumverbindung in einer Menge von 0,001 bis 60 Masseteilen je 100 Masseteile der Gesamtzubereitung enthält.

4. Zubereitung nach einem der Ansprüche 1 bis 3, **dadurch gekennzeichnet, daß** die Magnesiumverbindung ausgewählt ist aus der aus Magnesiumoxid, Magnesiumhydroxid, Magnesiumcarbonat, Magnesiumsilikat, Magnesiumcarboxylaten, Magnesiumchelaten und Magnesiumalkoholaten bestehenden Gruppe.

5. Zubereitung nach einem der Ansprüche 1 bis 4, **dadurch gekennzeichnet, daß** sie die Magnesiumverbindung in dispergierter, feinteiliger Form mit einer Korngröße von höchstens 50 μm enthält.

**6.** Zubereitung nach einem der Ansprüche 1 bis 5, **dadurch gekennzeichnet, daß** die mindestens eine polymerisierbare Verbindung eine mindestens eine Epoxidgruppe enthaltende Verbindung ist, die aus der aus Glycidylethem und Epoxycyclohexylgruppen enthaltenden Verbindungen bestehenden Gruppe ausgewählt ist.

**7.** Zubereitung nach einem der Ansprüche 1 bis 6, **dadurch gekennzeichnet, daß** die Fluoratome in den fluorhaltigen Verbindungen, soweit es sich um komplexe Anionen handelt, teilweise durch OH-Gruppen substituiert sind.

**8.** Zubereitung nach einem der Ansprüche 1 bis 7, **dadurch gekennzeichnet, daß** sie zusätzlich mindestens einen feinteiligen Füllstoff, ausgewählt aus der aus Quarzmehl, Quarzgutmehl und pyrogener Kieselsäure bestehenden Gruppe, enthält.

**9.** Verwendung der Zubereitung gemäß einem der Ansprüche 1 bis 8 für das Verkleben, Vergießen und Beschichten von elektronischen Bauelementen.

**10.** Verwendung der Zubereitung gemäß einem der Ansprüche 1 bis 9 für die Montage elektronischer Bauelemente auf Leiterplatten.

**11.** Verwendung der Zubereitung gemäß einem der Ansprüche 1 bis 10 für die Herstellung medizintechnischer Artikel.

**12.** Verfahren zur Herstellung ausgehärteter Polymermassen mit reduziertem Gehalt an mit Wasser extrahierbaren Fluoridionen, bei dem eine polymerisierbare fluorhaltige Zubereitung, die mindestens eine polymerisierbare Verbindung und mindestens eine fluorhaltige Verbindung enthält, polymerisiert und ausgehärtet wird, **dadurch gekennzeichnet, daß** der fluorhaltigen Zubereitung vor der Polymerisation mindestens eine Magnesiumverbindung zugesetzt wird.

**13.** Verfahren nach Anspruch 12, **dadurch gekennzeichnet, daß** die mindestens eine Magnesiumverbindung in einer Menge von 0,001 bis 60 Masseteilen je 100 Masseteile der Gesamtzubereitung zugesetzt wird.

**14.** Verfahren nach Anspruch 12 oder 13, **dadurch gekennzeichnet, daß** die Magnesiumverbindung ausgewählt wird aus der aus Magnesiumoxid, Magnesiurnhydroxid, Magnesiumcarbonat, Magnesiumsilikat, Magnesiumcarboxylaten, Magnesiumchelaten und Magnesiumalkoholaten bestehenden Gruppe.

**15.** Verfahren nach einem der Ansprüche 12 bis 14, **dadurch gekennzeichnet, daß** die Magnesiumverbindung in dispergierter, feinteiliger Form mit einer Korngröße von höchstens 50 µm zugesetzt wird.

**16.** Verfahren nach einem der Ansprüche 12 bis 15, **dadurch gekennzeichnet, daß** als fluorhaltige Zubereitung eine Zubereitung gemäß einem der Ansprüche 6 bis 8 verwendet wird.

**Claims**

**1.** A polymerizable fluorine-containing composition containing at least one polymerizable compound and at least one fluorine-containing compound selected from the group consisting of: tetrakis(pentafluorophenyl)borate, hexafluoroantimonate, hexafluoroarsenate, hexafluorophosphate, tetrafluoroborate, a complex of borofluoride with water, alcohols, ethers, thioethers, ammonia, amines, carboxylic acids, ketones, and aldehydes and/or a complex of borofluoride with compounds comprising at least one secondary amino group, and additionally containing at least one magnesium compound, **characterized in that** it has, after curing, a content of fluoride ions extractable with water which is lower by at least 40% as compared with the content of fluoride ions extractable with water of an otherwise identical composition which does not contain a magnesium compound.

**2.** The composition of claim 1, **characterized in that** the content of fluoride ions extractable after curing is lower by at least 60% than without a magnesium compound.

**3.** The composition of claim 1 or claim 2, **characterized in that** it contains said at least one magnesium compound in an amount of from 0.001 to 60 parts by mass per 100 parts by mass of the total composition.

**4.** The composition of any one of claims 1 to 3, **characterized in that** said magnesium compound is selected from the group consisting of magnesia, magnesium hydroxide, magnesium carbonate, magnesium silicate, magnesium carboxylates, magnesium chelates, and magnesium alcoholates.

5.  The composition of any one of claims 1 to 4, **characterized in that** it contains said magnesium compound in a dispersed, finely divided form having a maximum particle size of 50 µm.

6.  The composition of any one of claims 1 to 5, **characterized in that** said at least one polymerizable compound is a compound which contains at least one epoxide group and which is selected from the group consisting of glycidyl ethers and compounds containing epoxycyclohexyl groups.

7.  The composition of any one of claims 1 to 6, **characterized in that** the fluorine atoms in said fluorine-containing compounds, as far as complex anions are concerned, are partially replaced by OH-groups.

8.  The composition of any one of claims 1 to 7, **characterized in that** it further contains at least one finely divided filler selected from the group consisting of quartz powder, fused silica powder, and pyrogenic silicic acid.

9.  Use of the composition according to any one of claims 1 to 8 for bonding, potting and coating of electronic devices.

10. Use of the composition according to any one of claims 1 to 8 for mounting electronic devices on printed circuit boards.

11. Use of the composition according to any one of claims 1 to 8 for the manufacture of articles of medical techniques.

12. A process for the preparation of cured polymer masses having a reduced content of fluoride ions extractable with water, comprising polymerizing and curing a polymerizable fluorine-containing composition containing at least one polymerizable compound and at least one fluorine-containing compound, **characterized in that** at least one magnesium compound is added to said fluorine-containing composition, prior to the polymerization.

13. The process of claim 12, **characterized in that** said at least one magnesium compound is added in an amount of from 0.001 to 60 parts by mass per 100 parts by mass of the total composition.

14. The process of claim 12 or 13, **characterized in that** said magnesium compound is selected from the group consisting of magnesia, magnesium hydroxide, magnesium carbonate, magnesium silicate, magnesium carboxylates, magnesium chelates, and magnesium alcoholates.

15. The process of any one of claims 12 to 14, **characterized in that** said magnesium compound is added in a dispersed, finely divided form having a maximum particle size of 50 µm.

16. The process of any one of claims 12 to 15, **characterized in that** a composition according to any one of claims 6 to 8 is used as said fluorine-containing composition.


**Revendications**

1.  Composition fluorée polymérisable contenant au moins un composé polymérisable et au moins un composé fluoré choisi dans le groupe : tétrakis(pentafluorophényl)borate, hexafluoroantimoniate, hexafluoro-arséniate, hexafluorophosphate, tétrafluoroborate, un complexe de fluorure de bore avec l'eau, alcools, éthers, thioéthers, ammoniac, amines, acides carboxyliques, cétones et aldéhydes et/ou un complexe de fluorure de bore avec des composés qui présentent au moins un groupe amino secondaire, ainsi qu'en plus au moins un composé de magnésium, **caractérisée par le fait qu'**elle présente après durcissement une teneur en ions fluorure extractibles à l'eau inférieure d'au moins 40 % à la teneur en ions fluorure extractibles à l'eau d'une préparation autrement identique qui ne contient pas de composé de magnésium.

2.  Préparation selon la revendication 1, **caractérisée par le fait que** la teneur en ions fluorure extractibles après durcissement est inférieure d'au moins 60 % à celle sans composé de magnésium.

3.  Préparation selon l'une des revendications 1 et 2, **caractérisée par le fait qu'**elle contient le ou les composés de magnésium en une quantité de 0,001 à 60 parties en masse pour 100 parties en masse de la préparation totale.

**4.** Préparation selon l'une des revendications 1 à 3, **caractérisée par le fait que** le composé de magnésium est choisi dans le groupe constitué de l'oxyde de magnésium, de l'hydroxyde de magnésium, du carbonate de magnésium, du silicate de magnésium, des carboxylates de magnésium, des chélates de magnésium et des alcoolates de magnésium.

**5.** Préparation selon l'une des revendications 1 à 4, **caractérisée par le fait qu'**elle contient le composé de magnésium sous forme finement divisée et dispersée avec une grosseur de grain d'au plus 50 μm.

**6.** Préparation selon l'une des revendications 1 à 5, **caractérisée par le fait que** le ou chaque composé polymérisable est un composé contenant au moins un groupe époxyde qui est choisi dans le groupe constitué des éthers de glycidyle et des composés contenant des groupes époxycyclohexyles.

**7.** Préparation selon l'une des revendications 1 à 6, **caractérisée par le fait que** les atomes de fluor des composés fluorés, s'il s'agit d'anions complexes, sont substitués en partie par des groupes OH.

**8.** Préparation selon l'une des revendications 1 à 7, **caractérisée par le fait qu'**elle contient en plus au moins une matière de charge finement divisée choisie dans le groupe constitué de la poudre de quartz, de la poudre d'acide silicique et de l'acide silicique pyrogène.

**9.** Utilisation de la préparation selon l'une des revendications 1 à 8 pour le collage, la coulée et le revêtement de composants électroniques.

**10.** Utilisation de la préparation selon l'une des revendications 1 à 9 pour le montage de composants électroniques sur des cartes imprimées.

**11.** Utilisation de la préparation selon l'une des revendications 1 à 10 pour la fabrication d'articles techniques médicaux.

**12.** Procédé de fabrication de matières polymères durcies à teneur réduite en ions fluorure extractibles à l'eau, dans lequel une préparation fluorée polymérisable qui contient au moins un composé polymérisable et au moins un composé fluoré est polymérisée et durcie, **caractérisé par le fait qu'**au moins un composé de magnésium est ajouté à la préparation fluorée avant la polymérisation.

**13.** Procédé selon la revendication 12, **caractérisé par le fait que** le ou les composés de magnésium sont ajoutés en une quantité de 0,001 à 60 parties en masse pour 100 parties en masse de la préparation totale.

**14.** Procédé selon l'une des revendications 12 et 13, **caractérisé par le fait que** le composé de magnésium est choisi dans le groupe constitué de l'oxyde de magnésium, de l'hydroxyde de magnésium, du carbonate de magnésium, du silicate de magnésium, des carboxylates de magnésium, des chélates de magnésium et des alcoolates de magnésium.

**15.** Procédé selon l'une des revendications 13 à 14, **caractérisé par le fait que** le composé de magnésium est ajouté sous forme finement divisée et dispersée avec une grosseur de grain d'au plus 50 μm.

**16.** Procédé selon l'une des revendications 12 à 15, **caractérisé par le fait que** comme préparation fluorée est utilisée une préparation selon l'une des revendications 6 à 8.